# EUROPÄISCHE PATENTSCHRIFT

(11) **EP 2 073 265 B1**
(45) Veröffentlichungstag und Bekanntmachung des Hinweises auf die Patenterteilung: **23.06.2010**
(21) Anmeldenummer: 08020122.1
(22) Anmeldetag: 19.11.2008
(51) Int. Cl.: H01L 25/16, H01L 23/48, H05K 1/14, H01L 25/07

(54) **Druckkontaktierung in einer Anordnung mit einem Leistungshalbleitermodul**
Pressure contact in an assembly comprising a power semiconductor module
Contact sous pression dans un dispositif comprenant un module semi-conducteur de puissance

(30) Priorität: 21.12.2007 DE 102007062163
(43) Veröffentlichungstag der Anmeldung: 24.06.2009
(73) Patentinhaber: SEMIKRON Elektronik GmbH & Co. KG, 90431 Nürnberg (DE)
(72) Erfinder: Lederer, Marco, 90453 Nürnberg (DE); Reusser, Lars, 96114 Hirschaid (DE)

(56) Entgegenhaltungen:
- EP-A- 1 450 404
- DE-A1-102004 021 122
- GB-A- 2 167 228
- US-A- 3 504 238

## Beschreibung

Die Erfindung beschreibt eine Anordnung mit einem kompakten Leistungshalbleitermodul, mit einem isolierenden Gehäuse, mit einem Kühlkörper, mit einer externen Leiterplatte und mit einer Druckeinrichtung.

Den Ausgangspunkt der Erfindung bildet die DE 196 30 173 C2, welche ein Leistungshalbleitermodul zur direkten Montage auf einer Kühleinrichtung offenbart, bestehend aus einem Gehäuse mit mindestens einem darin angeordneten elektrisch isolierenden Substrat vorzugsweise zur direkten Montage auf einem Kühlbauteil. Das Substrat seinerseits besteht aus einem Isolierstoffkörper mit einer Mehrzahl darauf befindlicher erster gegeneinander isolierter strukturierter metallischer Leiterbahnen und hierauf befindlichen und mit diesen Leiterbahnen schaltungsgerecht verbundenen Leistungshalbleiterbauelementen. Die externe elektrische Verbindung zu den zweiten Leiterbahnen einer außerhalb des Gehäuses angeordneten Leiterplatte erfolgt mittels Kontaktfedern.

Das Leistungshalbleitermodul weist weiterhin mindestens eine Ausnehmung zur Durchführung einer Schraubverbindung zu einem Kühlkörper auf. Diese dient zusammen mit einem auf der dem Leistungshalbleitermodul abgewandeten Seite der Leiterplatte angeordneten und auf dieser flächig aufliegenden, formstabilen Druckstück der Druckkontaktierung des Moduls. Diese Druckkontaktierung erfüllt gleichzeitig zwei Aufgaben: einerseits die sichere elektrische Kontaktierung der Anschlusselemente mit der Leiterplatte und andererseits die thermische Kontaktierung des Moduls mit dem Kühlkörper.

Aus der DE 195 33 298 A1 ist ein elektronisches Modul bekannt, bei dem der Kühlkörper teilweise durch das Gehäuse des Moduls umschlossen wird. Hierbei weist der Kühlkörper Rastnasen auf, die mit Widerlagern des Gehäuses eine Schnapp- RastVerbindung bilden und somit zusätzliche Verbindungselemente zwischen dem Modul und dem Kühlkörper erübrigen.

Aus der DE 10 2004 021 122 A1 ist weiterhin bekannt, eine irreversible Verbindung zwischen Gehäuse und Kühlkörper durch angeordnete Zapfen und diesen entsprechend zugeordneten Ausnehmungen, wobei die Zapfen an ihrem Ende beispielhaft durch Ultraschall- oder thermische Einwirkung derartig verformbar sind, dass sie eine Niete bilden, die sich durch die zugeordnete Ausnehmung auf einem zugeordneten Widerlager abstützt.

Aus der EP 1 450 404 A2 ist eine Druckkontaktierung für ein kompaktes Leistungshalbleitermodul zur direkten Montage auf einen Kühlkörper bekannt, dass ein formstabiles Druckstück zur Druckkontaktierung der Leiterplatte aufweist, welches an seiner der Leiterplatte zugewandten Hauptfläche eine Mehrzahl von Druckelementen aufweist, die die Hauptfläche von der Leiterplatte beabstanden.

Nachteilig an den Leistungshalbleitermodulen nach dem bisher genannten Stand der Technik ist, dass das bekannte Druckstück unverzichtbar zur sicheren elektrischen Kontaktierung der inneren und externen Kontaktelemente ist. Die Anordnung der Druckeinrichtung nach dem Stand der Technik erlaubt es nicht, in dem von ihr überdeckten Bereich auf der externen Leiterplatte Bauelemente, wie beispielhaft Widerstände, Kondensatoren oder integrierten Schaltungen anzubringen. Ein derart entstandener Mangel an verbaubarer Fläche auf der externen Leiterplatte schränkt deren Leistungsfähigkeit deutlich ein.

Der vorliegenden Erfindung liegt die Aufgabe zu Grunde, eine Anordnung mit einem Leistungshalbleitermodul, einer externen Leiterplatte, einer Kühleinrichtung und einer Druckeinrichtung vorzustellen, welche äußerst kompakte Ausmaße aufweist und ein größtmögliches Maß an nutzbarer Fläche zur Anordnung von Bauelementen auf der externen Leiterplatte gewährleistet.

Diese Aufgabe wird gelöst durch eine Anordnung nach dem Anspruch 1, spezielle Ausgestaltungen finden sich in den Unteransprüchen.

Der Grundgedanke der Erfindung geht aus von einem Leistungshalbleitermodul zur direkten Montage auf einer Kühleinrichtung, wobei das Leistungshalbleitermodul ein isolierendes Kunststoffgehäuse aufweist. Dieses Kunststoffgehäuse weist ein rahmenförmiges Teil und weiterhin eine vorzugsweise einstückig mit diesem rahmenförmigen Teil verbundene erste Deckfläche auf. Die erste Deckfläche des Gehäuses weist eine Mehrzahl von Ausnehmungen auf. Durch diese Ausnehmungen reichen Anschlusselemente zur elektrischen Verbindung der ersten Leiterbahnen des Leistungshalbleitermoduls mit Kontaktpunkten der zweiten Leiterbahnen der oberhalb der ersten Deckfläche angeordneten Leiterplatte. Diese Leiterplatte aus einem isolierenden Substrat mit darauf oder darin angeordneten Leiterbahnen stellt die elektrischen Anschlüsse des Leistungshalbleitermoduls dar und trägt vorzugsweise weitere Bauelemente zur Steuerung des Leistungshalbleitermoduls.

Die zweite Deckfläche des Leistungshalbleitermoduls wird gebildet durch ein Substrat, das aus einem flächigen Isolierstoffkörper und mindestens einer hierauf angeordneten metallischen Schicht besteht, die dem Leistungshalbleitermodulinneren zugewandte ist. Diese metallische Schicht kann in sich strukturiert sein und bildet somit die mindestens eine Leiterbahn des Leistungshalbleitermoduls. Auf dieser/n Leiterbahnen ist mindestens ein Leistungshalbleiterbauelement angeordnet und mit einer weiteren Leiterbahn und / oder einem weiteren Leistungshalbleiterbauelement schaltungsgerecht verbunden.

An der zweiten Deckfläche ist auf der dem Leistungshalbleitermodulinneren abgewandten Seite eine vorzugsweise aktive Kühleinrichtung angeordnet. Aktive Kühleinrichtungen, beispielhaft ein Kühlkörper mit hieran angeordnetem ungeregelten oder einen temperaturgeregelten Lüfter, weisen gegenüber passiven Kühleinrichtungen, beispielhaft einem Luftkühler, den wesentlichen Vorteil einer kompakteren Bauform auf.

Die Anschlusselemente sowohl für Last- als auch für Steueranschlüsse des Leistungshalbleitermoduls sind zumindest teilweise federnd gestaltete Anschlussleiter. Diese Anschlussleiter stellen die elektrische Verbindung der Verbindungsbahnen mit der außerhalb des Gehäuses angeordneten Leiterplatte und den darauf angeordneten externen Leiterbahnen her. Der sichere elektrische Kontakt zwischen den Anschlussleitern und den externen Leiterbahnen der Leiterplatte wird mittels einer Druckkontaktierung erzielt.

Die Druckeinrichtung besteht aus einem flexiblen, vorzugsweise thermostabilen Isolierstoffkörper, welcher vorzugsweise aus einem elastomeren Silikonkautschuk ausgebildet ist und das Leistungshalbleitermodul mantelartig, jedoch nicht notwendigerweise an dem Gehäuse anliegend, vollständig umschließt sowie mit seinen oberen und unteren Endflächen hermetisch dicht an der unteren Fläche der Leiterplatte und an der oberen Fläche des Kühlkörpers anliegt. Weiterhin weist die Druckeinrichtung eine Ausnehmung aus, welche dazu dient, durch Absaugen der im Inneren des Isolierstoffkörpers befindlichen Luft einen Unterdruck zu erzeugen, welcher in Relation zum außerhalb der Druckeinrichtung herrschenden Umgebungsdruck zu einer kraftschlüssigen Verbindung und damit zu einer zuverlässigen elektrisch leitenden Kontaktierung zwischen der externen Leiterplatte und den Last- und Hilfsanschlüssen an der ersten Deckfläche des Leistungshalbleitermoduls führt. Durch abschließendes Verschließen der Ausnehmung, vorzugsweise mittels Heißverkleben der Ausnehmung, wird der Unterdruck innerhalb des Isolierstoffkörpers dauerhaft erhalten und somit einer beständiger gleichmäßiger Kraftschluss zwischen den Last- und Hilfsanschlüssen des Leistungshalbleitermoduls und den Leiterbahnen der externen Leiterplatte erreicht.

Hierbei ist es erfindungsgemäß von Vorteil, dass unter dem Verzicht eines druck einleitenden Elements auf der dem Leistungshalbleitermodul abgewandten Seite der externen Leiterplatte die mit Bauelementen zu beaufschlagende Fläche der externen Leiterplatte erheblich vergrößert werden kann.

Vorzugsweise kann zur Sicherung der Dichtfunktion an den Endflächen des Isolierstoffkörpers eine thermoplastische Dichtmasse oder ein entsprechender Klebstoff aufgebracht werden, um die Zuverlässigkeit des Kraftschlusses zu erhöhen. Weiterhin kann eine oder beide Endflächen zusätzliche Dichtlippen zum Schutz des Inneren des Leistungshalbleitermoduls vor Staub und/oder Feuchtigkeit aufweisen. Selbige Dichtlippen können auch beispielhaft ausgestaltet sein, um die eigentliche Dichtfunktion in Hinblick auf die Erzeugung und Erhaltung des notwendigen Unterdrucks zu unterstützen.

Beispielhaft kann weiterhin die Zuverlässigkeit der Verbindung zwischen Leistungshalbleitermodul und Kühleinrichtung durch einen Stoff- oder Kraftschluss mittels Heißverstemmen, Kleben, Schnapp-Rasten oder anderen Verbindungstechniken erreicht werden.

Die Erfindung wird anhand von Ausführungsbeispielen in Verbindung mit den Fig. 1 bis 4 näher erläutert.

Fig. 1 zeigt im Querschnitt eine vereinfachte Darstellung einer Anordnung gemäß dem beschriebenen Stand der Technik.

Fig. 2 zeigt im Querschnitt eine vereinfachte Darstellung einer erfindungsgemäßen Weiterbildung der Anordnung.

Fig. 3 zeigt eine dreidimensionale Ansicht der erfindungsgemäßen Anordnung.

Fig. 4 zeigt einen Profilschnitt durch die Druckeinrichtung der erfindungsgemäßen Anordnung.

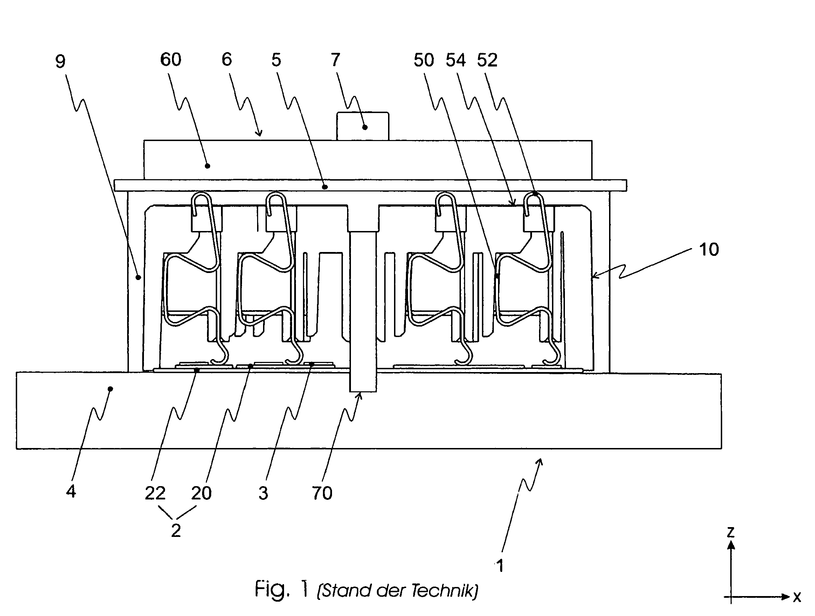

Fig. 1 zeigt einen Schnitt durch eine Anordnung (1) gemäß dem Stand der Technik mit einem druckkontaktierten Leistungshalbleitermodul (10) mit einem Gehäuse (9), mit einer Kühleinrichtung (4), mit einem Substrat (2) und einer externen Leiterplatte (5), wobei das Substrat (2) des Leistungshalbleitermoduls einen Isolierstoffkörper (22) mit darauf angeordneten strukturierten Leiterbahnen (20) und darauf angeordneten Bauelementen (3) aufweist und die Last- und Hilfsanschlüsse (50) als Federkontakte ausgebildet sind, welche durch das Gehäuse des Leistungshalbleitermoduls durch die obere Deckfläche (54) des Leistungshalbleitermoduls die elektrische Kontaktierung (52) mit der externen Leiterplatte (5) ermöglichen. Weiterhin weist die Anordnung gemäß dem Stand der Technik eine Druckeinrichtung (6) auf, bestehend aus einem druck einleitenden Element (60) und dem Gehäuse (9). Mittels mindestens einer Schraubverbindung (7), welche durch Ausnehmungen in der externen Leiterplatte und dem Gehäuse und dem Substrat in den Kühlkörper reicht (70) und hierbei die kraftschlüssige Verbindung aller genannten Elemente ermöglicht.

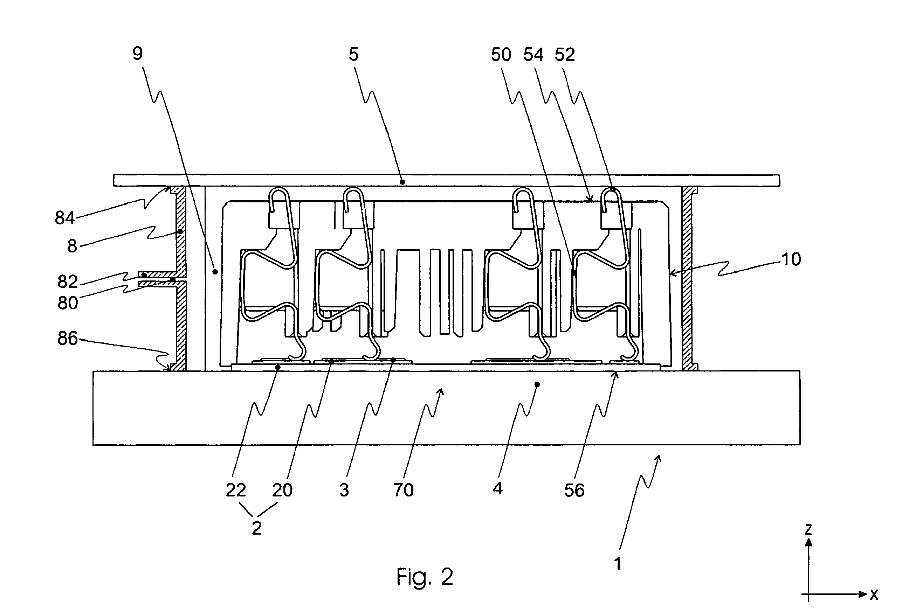

Fig. 2 zeigt einen Schnitt durch eine erfindungsgemäße Weiterbildung des Standes der Technik, wobei hier baugleiche Elemente zu Fig. 1 nicht extra beschrieben sind. Die Druckeinrichtung weist hier einen thermoplastischen Isolierstoffkörper (8) auf, welcher das Leistungshalbleitermodul mantelartig vollständig umschließt, jedoch nicht vollständig am Gehäuse anliegt und sich somit zwischen dem Gehäuse und dem Isolierstoffkörper ein Luftvolumen befindet. Der Isolierstoffkörper schließt mit seiner ersten Endfläche (84) in der Ebene der oberen Deckfläche (54) des Leistungshalbleitermoduls flächenbündig mit der externen Leiterplatte ab. Ebenso schließt der Isolierstoffkörper mit seiner zweiten Endfläche (86) in der Ebene der unteren Deckfläche (56) flächenbündig mit dem Kühlkörper ab. Der Isolierstoffkörper weist weiterhin eine Ausnehmung auf (80), durch welche die Luftabsaugung zur Erzeugung des Unterdrucks erfolgt. Das die Ausnehmung umgebende Randmaterial ist hier an der Außenfläche des Isolierstoffkörpers derart verlängert, dass eine Nase (82) zur besseren Zugänglichkeit zur Luftabsaugung, beispielhaft mittels einer Pumpe, ausgebildet ist. Weiterhin ist (nicht dargestellt) zur Sicherung der Verbindung zwischen Leistungshalbleitermodul und Kühleinrichtung die untere Deckfläche (56) mit der zugeordneten Fläche des Kühlkörpers verklebt.

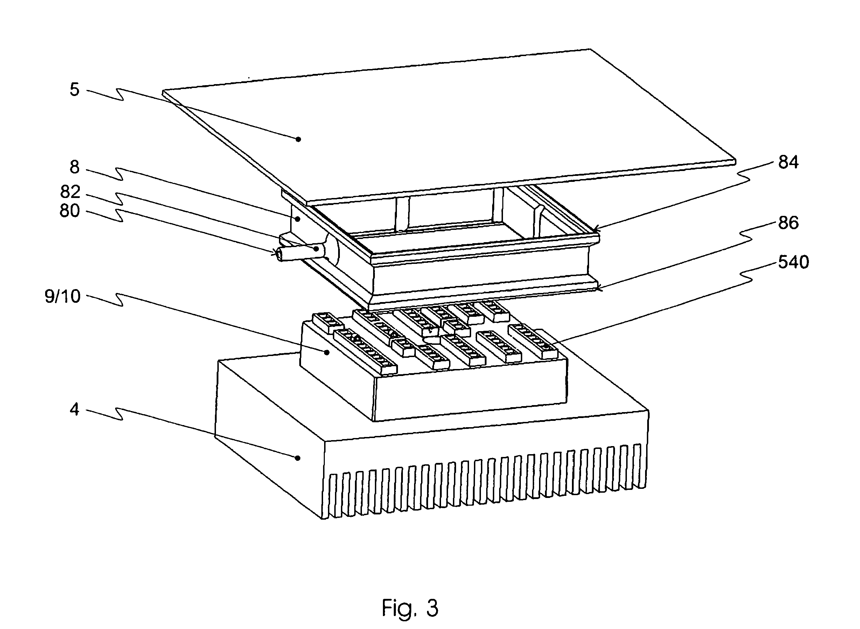

Fig. 3 zeigt eine dreidimensionale Ansicht der erfindungsgemäßen Anordnung (1) in Explosionszeichnung mit dem Kühlkörper (4), dem Leistungshalbleitermodul (10), wobei hier perspektivisch das Gehäuse (9) sichtbar ist, weiterhin die Druckeinrichtung mit dem mantelartigen Isolierstoffkörper (8) und mit dem einstückig ausgebildeten Fortsatz (82) und der Ausnehmung (80) zur Luftabsaugung und Unterdruckerzeugung. Weiterhin sichtbar ist die externe Leiterplatte (5) und die ihr zugewandte erste Endfläche (84) des mantelartigen Isolierstoffkörpers, sowie der Kühleinrichtung (4) zugewandte zweite Endfläche (86) des mantelartigen Isolierstoffkörpers.

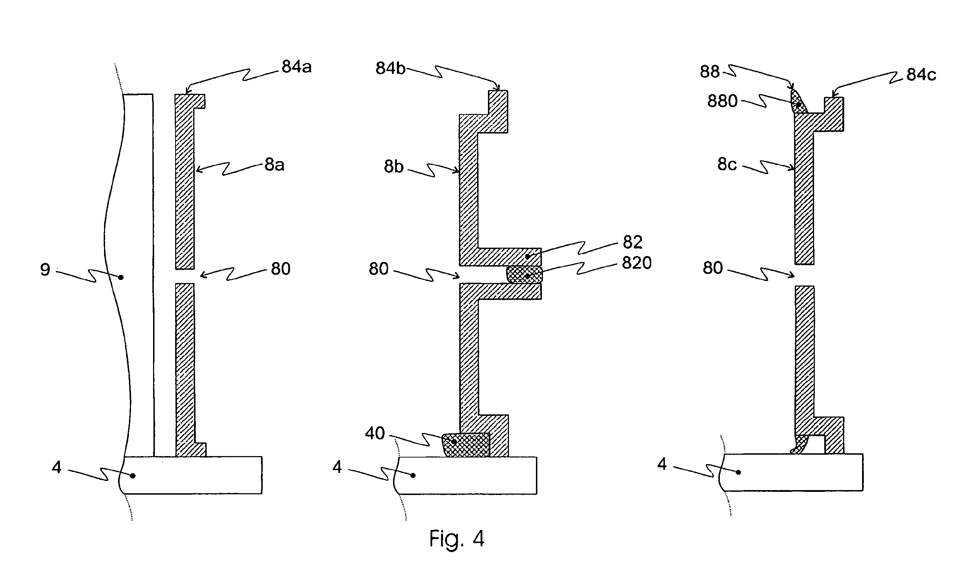

Fig. 4 zeigt einen Profilschnitt durch den Isolierstoffkörper der erfindungsgemäßen Anordnung in verschiedenen möglichen Ausführungsarten mit jeweils sichtbarer Ausnehmung (80) sowie einen Ausschnitt des angeordneten Kühlkörpers (4). Fig. 4a zeigt hierbei zur Verdeutlichung zusätzlich einen Ausschnitt des angeordneten Kunststoffgehäuses (9) des Leistungshalbleitermoduls. Hierbei sind die Endflächen (84a) in Relation zur Materialdicke der Wandung des Isolierstoffkörpers (8a) deutlich verbreitert und liegen vollflächig an der externen Leiterplatte und dem Kühlkörper an.
In einem weiteren Ausführungsbeispiel (Fig. 4b) entspricht die Materialdicke der Endfläche (84b) der Materialdicke der Wandung des Isolierstoffkörpers (8b) jedoch sind die Endflächen in ihrer relativen Position zum Isolierstoffkörper seitlich versetzt, um eine höhere elastische Flexibilität der Endfläche zu erreichen und damit die Dichtfunktion zu erhöhen. Weiterhin ist hier die aus dem Randmaterial der Ausnehmung (80) gebildete Nase (82) sichtbar, welche nach Erzeugung des Unterdrucks mit Dichtmasse (820) verschlossen wird. Weiterhin entsteht durch den seitlichen Versatz der Endfläche des Isolierstoffkörpers zwischen diesem und dem Kühlkörper ein Volumen, welches hier zur Sicherung der Dichtfunktion mit Klebstoff (40) verfüllt wird.
In einem weiteren Ausführungsbeispiel (Fig. 4c) sind die Endflächen (84c) mit zusätzlich ausgebildeten Dichtlippen (88) versehen, um die Dichtfunktion hinsichtlich Erhaltung des Unterdrucks und zwecks eines weitergehenden Staub- und Feuchtigkeitsabdichtung zu erreichen. Hierbei sind die Dichtlippen (88) aus einem zweiten, einstückig elastischeren Kunststoffmaterial (880) gebildet, um das kraftschlüssige Anliegen der Dichtlippe an der Kühleinrichtung und an der externen Leiterplatte zu erleichtern und hiermit die Dichtfunktion weiterhin zu verbessern.

## Patentansprüche

1. Anordnung mit einem Leistungshalbleitermodul (10), mit einer externen Leiterplatte (5), mit einer Kühleinrichtung (4) und mit einer Druckeinrichtung,
wobei das Leistungshalbleitermodul (10) ein isolierendes Kunststoffgehäuse (9) mit einer ersten Deckfläche (54) mit dort angeordneten Ausnehmungen (540), ein die zweite Deckfläche (56) des Gehäuses bildendes Substrat (2) mit voneinander isolierten Leiterbahnen (20) und mindestens einem hierauf angeordneten und schaltungsgerecht verbundenen Leistungshalbleiterbauelement (3) sowie mindestens einem Kontaktelement (50), das durch die Ausnehmungen an der ersten Deckfläche des Gehäuses (9) hindurchreicht, zur Verbindung der Leiterbahn (20) des Substrats (2) mit Kontaktstellen (52) der Leiterplatte (5) aufweist,
wobei die Druckeinrichtung einen rahmenförmigen Isolierstoffkörper (8) mit mindestens einer verschlossenen Ausnehmung (80) aufweist und wobei dieser Isolierstoffkörper das zwischen der externen Leiterplatte und der Kühleinrichtung (4) positionierte Leistungshalbleitermodul in seinem gesamten Volumen umschließt und im Inneren des Isolierstoffkörpers ein Unterdruck in Relation zum Umgebungsdruck besteht und der Isolierstoffkörper mit seiner der externen Leiterplatte (5) zugewandten ersten Endfläche (84) mit dieser eine flächenbündige kraftschlüssige Verbindung darstellt und mit seiner der Kühleinrichtung (4) zugewandten zweiten Endfläche (86) mit diesem ebenfalls eine flächenbündige kraftschlüssige Verbindung darstellt.

2. Anordnung nach Anspruch 1,
wobei die Ausnehmung (80) des Isolierstoffkörpers an der orthogonal zu den ersten und zweiten Deckflächen (54, 56) des Gehäuses angeordneten Fläche des Isolierstoffkörpers angeordnet ist.

3. Anordnung nach Anspruch 2,
wobei die Ausnehmung (80) einen einstückig aus dem Isolierstoffkörper ausgebildeten Fortsatz (82) aufweist.

4. Anordnung nach Anspruch 1,
wobei der Isolierstoffkörper thermoplastische Eigenschaften aufweist.

5. Anordnung nach Anspruch 1,
wobei der Isolierstoffkörper elastomere Eigenschaften aufweist.

6. Anordnung nach Anspruch 1,
wonach der Isolierstoffkörper an seinen ersten und zweiten Endflächen (84, 86) eine Dichtungsmasse oder einen Klebstoff (40) aufweist.

7. Anordnung nach Anspruch 1,
wonach das Leistungshalbleitermodul und die Kühleinrichtung eine kraft- oder stoffschlüssige Verbindung aufweisen.

## Claims

1. An arrangement with a power semiconductor module (10), with an external printed circuit board (5), with a cooling device (4), and with a pressure device, wherein
the power semiconductor module (10) has an insulating plastic housing (9) with a first top surface (54) with openings (540) there arranged, a substrate (2) forming the second top surface (56) of the housing with conducting tracks (20) insulated from one another, and at least one power semiconductor component (3) hereupon arranged and connected in accordance with the circuit in question, and also at least one contact element (50), which extends through the openings on the first top surface of the housing (9), for the connection of the conducting track (20) of the substrate (2) with contact points (52) of the printed circuit board (5), wherein
the pressure device has an insulating material body (8) in the form of a frame with at least one closed opening (80) and wherein this insulating material body encloses the whole volume of the power semiconductor module positioned between the external printed circuit board and cooling device (4), and a pressure reduced in relation to the ambient pressure is present in the interior of the insulating material body, and the insulating material body with its first end face facing towards the external printed circuit board (5) constitutes a flush force-fit connection with the latter, and with its second end face (86) facing towards the cooling device (4) likewise constitutes a flush force-fit connection with the latter.

2. The arrangement according to Claim 1, wherein
the opening (80) of the insulating material body is arranged on the surface of the insulating material body arranged orthogonal to the first and second top surfaces (54, 56) of the housing.

3. The arrangement according to Claim 2, wherein
the opening (80) has a projection (82) integrally formed from the insulating material body.

4. The arrangement according to Claim 1, wherein
the insulating material body has thermoplastic properties.

5. The arrangement according to Claim 1, wherein
the insulating material body has elastomeric properties.

6. The arrangement according to Claim 1, whereby
the insulating material body has on its first and second end faces (84. 86) a sealing compound or an adhesive (40).

7. The arrangement according to Claim 1, whereby
the power semiconductor module and the cooling device have a force-fit or a material-fit connection.

## Revendications

1. Agencement comprenant un module à semi-conducteurs de puissance (10), une plaque de circuits imprimés (5) externe, un dispositif de refroidissement (4) et un dispositif de pression,
le module à semi-conducteurs de puissance (10) présentant un boîtier en matière plastique (9) isolant avec une première surface de recouvrement (54) avec des évidements (540) disposés dessus, un substrat (2) formant la seconde surface de recouvrement (56) du boîtier avec des pistes conductrices (20) isolées les unes des autres et au moins un composant à semi-conducteurs de puissance (3) disposé dessus et relié de façon conforme au circuit et au moins un élément de contact (50) qui traverse les évidements sur la première surface de recouvrement du boîtier (9), pour la liaison de la piste conductrice (20) du substrat (2) avec des points de contact (52) de la plaque de circuits imprimés (5),
le dispositif de pression présentant un corps en matériau isolant (8) en forme de cadre avec au moins un évidement (80) fermé et ce corps en matériau isolant entourant le module à semi-conducteurs de puissance positionné entre la plaque externe de circuits imprimés et le dispositif de refroidissement (4) dans l'ensemble de son volume et une dépression par rapport à la pression ambiante existant à l'intérieur du corps en matériau isolant et le corps en matériau isolant avec sa première surface d'extrémité (84), tournée vers la plaque externe de circuits imprimés (5), représentant avec celle-ci une liaison par adhérence des forces au niveau de la surface et avec sa seconde surface d'extrémité (86) tournée vers le dispositif de refroidissement (4), avec celle-ci également une liaison par adhérence des forces au niveau de la surface.

2. Agencement selon la revendication 1,
l'évidement (80) du corps en matériau isolant étant disposé sur la surface du corps en matériau isolant qui est disposée de façon perpendiculaire aux première et seconde surfaces de recouvrement (54, 56) du boîtier.

3. Agencement selon la revendication 2,
l'évidement (80) présentant un prolongement (82) conçu d'une seule pièce à partir du corps en matériau isolant.

4. Agencement selon la revendication 1,
le corps en matériau isolant présentant des propriétés thermoplastiques.

5. Agencement selon la revendication 1,
le corps en matériau isolant présentant des propriétés élastomères.

6. Agencement selon la revendication 1,
le corps en matériau isolant présentant une masse d'étanchéité ou une colle (40) sur ses première et seconde surfaces d'extrémité (84, 86).

7. Agencement selon la revendication 1,
le module à semi-conducteurs de puissance et le dispositif de refroidissement présentant une liaison par adhérence des forces ou une liaison par adhésion de matière.
